(19) **Europäisches Patentamt / European Patent Office / Office européen des brevets**

(11) **EP 4 723 076 A1**

(12) **EUROPEAN PATENT APPLICATION**

(43) Date of publication:
08.04.2026 Bulletin 2026/15

(21) Application number: 24204641.5

(22) Date of filing: 04.10.2024

(51) International Patent Classification (IPC):
*G08G 1/01* $^{(2006.01)}$     *G06F 30/20* $^{(2020.01)}$

(52) Cooperative Patent Classification (CPC):
G08G 1/0141; G06F 30/20; G08G 1/0112;
G08G 1/0116; G08G 1/012; G08G 1/0129;
G08G 1/0133; G08G 1/0145

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicant: **FUJITSU LIMITED**
**Kawasaki-shi, Kanagawa 211-8588 (JP)**

(72) Inventors:
• **OLMEZ, Sedar**
  **Slough, SL1 2BE (GB)**
• **SMILOVITSKIY, Maxim**
  **Slough, SL1 2BE (GB)**

(74) Representative: **Haseltine Lake Kempner LLP**
**Cheapside House**
**138 Cheapside**
**London EC2V 6BJ (GB)**

Remarks:
Amended claims in accordance with Rule 137(2)
EPC.

(54) **METHOD AND APPARATUS FOR TRAFFIC SIMULATION**

(57)     A computer-implemented method for traffic simulation, the method comprising: executing a preliminary agent-based simulation model to generate a preliminary simulation prediction of traffic in a geographic area; accepting input of traffic data for the geographic area; performing data assimilation on the preliminary simulation prediction and the traffic data to generate assimilated traffic data.

| Execute a preliminary agent-based simulation model to generate a preliminary simulation prediction of traffic in a geographic area | S11 |

| Accept input of traffic data for the geographic region | S12 |

| Perform data assimilation on the preliminary simulation prediction and the traffic data to generate assimilated traffic data | S13 |

Figure 1

EP 4 723 076 A1

**Description**

**Field of the Invention**

The present invention relates to traffic simulations. More particularly, the present invention relates to methods for traffic simulations and related data processing apparatuses, computer programs, and computer-readable storage media.

**Background of the Invention**

There exists a trend where the real world may be represented as a digital world. Concepts such as Smart Cities, Digital Twins (DTs), and the Metaverse have received particular attention, at least in part due to the new and improved technologies that enable advancements within these concepts, such as technologies related to Internet of Things (IoT), 5th Generation technology standard for telecommunications (5G), Artificial Intelligence (AI), and quantum computing.

For improvements related to transport, smart traffic systems are used to deliver a wide range of services to varied users at scale and in real time (or at least fast enough for effective action to be taken). It is desirable for systems to deliver a wide range of services, created by complex processing of primarily real-time sensed data acquired from sources in (or serving) a transport network (for example, from roads and from vehicles). The services are often required in "real time", such that immediate action to be taken by the users of the services. There are diverse data sources, generating different types of data at different rates. The services are also diverse and complex, using the data in a wide range of different ways.

As an example, a transport authority for a large city may create a simulation in the form of a system DT of its public transport infrastructure that provides a real-time virtual model of the flow of traffic throughout the city. The virtual model may be driven by data generated from a wide variety of sources in real time, including: vehicle movements from in-vehicle GPS, roadside sensors, CCTV analysis, routing requests, live dispatches of public transport, etc.; the state and operation of infrastructure, such as traffic lights; and movements of people, from mobile GPS, ticketing activity, CCTV, etc.

Agent-based modelling (ABM) is a computational modelling framework for simulating the actions and interactions of autonomous agents (both individual and collective entities such as organizations or groups). ABM is a modelling paradigm that incorporates an agent which is a piece of code that represents the individual entity of interest and an environment in which the agent(s) reside and interact. ABM has enabled computational social scientists and others to simulate a wide range of empirically observed phenomena within a computational sandbox environment, stress testing a system before adoption. Typically, an agent-based model is made up of two components, the agent and environment.

The agent is an autonomous individual, often described as a software object that represents behaviour at the individual level. For example, an agent may represent a person, with characteristics such as age, height, weight. The environment represents some constrained space that may either be abstract or based on empirical data of the built-environment, within which the agents operate. With its widespread cross-disciplinary adoption, challenges of the ABM approach have been identified and investigated at length. One of the most prominent of these is the computational tractability of simulating intensive tasks. Sometimes, to overcome this challenge, modellers opt to reduce the complex representation of the real-world system by approximating complex behaviours or reducing the population of agents to the detriment of the simulation outcomes.

Modern ABMs are composed of rule-following agents (usually encoded as algorithms) that dynamically interact with their environment and/or each other. The state of each agent is usually contained in their state variables, which may be modified based on the interactions of the agent. The agents simulate local (microscopic) interactions that may lead to complex, emergent phenomena at various spatio-temporal scales. Recent increases in the availability of computing power have increased the uptake of such methods greatly increasing their popularity in research.

Microscopic ABMs take a detailed, bottom-up approach to modelling vehicular traffic. Unlike macroscopic models that focus on traffic flow as a whole, microscopic ABMs treat individual vehicles (and sometimes pedestrians) as independent agents with their own characteristics and decision-making capabilities. This allows for a more realistic simulation of traffic behaviour, taking into account factors like: individual driver behaviour (each agent may have different levels of aggression, patience, and skill, leading to diverse driving styles); vehicle characteristics (different vehicle types (cars, trucks, motorcycles) may have different acceleration, deceleration, and turning capabilities); environmental factors (traffic signals, lane markings, road geometry, and weather conditions may all impact agent behaviour); interactions between agents (agents may react to each other's actions, like changing lanes, braking, or merging, leading to emergent traffic phenomena like congestion and bottlenecks).

Effective traffic simulation techniques ideally possess such characteristics: the ability to model large scale and complex networks; the ability to simulate the evolution of a system faster than the real time; and the ability to provide accurate predictions and quickly react to changing conditions in the real world. These characteristics require the ability to quickly acknowledge and integrate information that comes from the real world in the form of road traffic data, weather forecast, changing movement patterns of people, social events, updated regulations, etc. Challenges exist given that this type of data is often noisy and is often provided with high dimensionality. Human movement and mobility is a non-linear complex system, hence simulation is very sensitive to initial conditions. Simulation with high-dimensional data often requires high computational power and large amounts of physical memory, which translates into hardware and time complexity related drawbacks.

It is desirable to provide techniques that offer improvements in realistic simulations of scenarios in digital representations of the real world.

## Summary of the Invention

The invention is defined in the independent claims. Specific embodiments are defined in the dependent claims.

According to an aspect of the invention, there is provided a computer-implemented method for traffic simulation, the method comprising: executing a preliminary agent-based simulation model to generate a preliminary simulation prediction of traffic in a geographic area; accepting input of traffic data for the geographic area; and performing data assimilation on the preliminary simulation prediction and the traffic data to generate assimilated traffic data.

Embodiments of another aspect of the invention include a data processing apparatus, which comprises a memory, a plurality of processing units, and means for accepting input. The memory stores computer-executable instructions to carry out a computer-implemented method for traffic simulation. The plurality of processing units and the means for accepting input are configured to execute the instructions.

Embodiments of another aspect of the invention include a computer program comprising instructions, which, when executed a data processing apparatus, causes the data processing apparatus to execute a computer-implemented method for a traffic simulation.

Embodiments of another aspect of the invention include a non-transitory computer-readable storage medium comprising instructions, which, when executed by a data processing apparatus, cause the data processing apparatus to execute a computer-implemented method for traffic simulation.

The invention may be implemented in digital electronic circuitry, or in computer hardware, firmware, software, or in combinations thereof. The invention may be implemented as a computer program or a computer program product, i.e., a computer program tangibly embodied in a non-transitory information carrier, e.g., in a machine-readable storage device or in a propagated signal, for execution by, or to control the operation of, one or more hardware modules.

A computer program may be in the form of a stand-alone program, a computer program portion, or more than one computer program, and may be written in any form of programming language, including compiled or interpreted languages, and it may be deployed in any form, including as a stand-alone program or as a module, component, subroutine, or other unit suitable for use in a data processing environment. A computer program may be deployed to be executed on one module or on multiple modules at one site or distributed across multiple sites and interconnected by a communication network.

Method steps of the invention may be performed by one or more programmable processors executing a computer program to perform functions of the invention by operating on input data and generating output. Apparatus of the invention may be implemented as programmed hardware or as special purpose logic circuitry, including e.g., an FPGA (field programmable gate array) or an ASIC (application-specific integrated circuit).

Processors suitable for the execution of a computer program include, by way of example, both general and special purpose microprocessors, and any one or more processors of any kind of digital computer. Generally, a processor will receive instructions and data from a read-only memory or a random access memory or both.

The invention is described in terms of particular embodiments. Other embodiments are within the scope of the following claims. For example, the steps of the invention may be performed in a different order and still achieve desirable results.

Aspects of embodiments have been described using such terms as "computing means" and "processing unit". The skilled person will appreciate that such functional terms and their equivalents may refer to parts of the system that are spatially separate but combine to serve the function defined. Equally, the same physical parts of the system may provide two or more of the functions defined. For example, separately defined means may be implemented using the same memory and/or processor as appropriate.

## Brief Description of the Drawings

Reference is made, by way of example only, to the accompanying drawings in which:

> FIGURE 1 is a flowchart of a general method for traffic simulation according to embodiments;
> FIGURE 2a and FIGURE 2b are sets of time series for an object position and velocity captured using a Kalman filter;
> FIGURE 3a and FIGURE 3b is a flowchart of a method for traffic simulation according to an embodiment; and
> FIGURE 4 is a block diagram of computational means for implementation of methods according to embodiments.

## Detailed Description

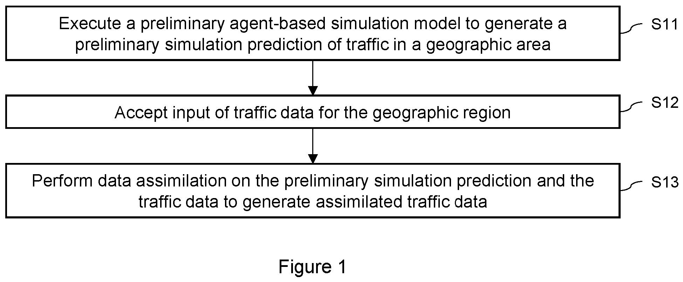

FIGURE 1 is an overview of a general method for traffic simulation, which addresses the above-described shortcomings of known simulation techniques. At S11, the computing means that is implementing the general method executes a preliminary microscopic agent-based simulation model to generate a preliminary simulation prediction result of traffic in a geographic area. In this way, the method simulates the behaviour of any traffic participants as represented by the agent objects. In the context of vehicle traffic for instance, a microscopic traffic simulation may be a mathematical traffic model or flow model that simulates single vehicle-driver units, so the dynamic variables of the models represent microscopic properties of the vehicles such as position and velocity. Each agent object is representative of a traffic participant and that traffic participant's associated data. For instance, an agent object may be a software object that represents behaviour of a single vehicle (where the associated data includes that vehicle's speed and position), or may be a software object that represents a segment of road within the geographic area. The geographic area may correspond to, for instance, an entire town or an entire city. Depending on the complexity of the simulation, there may be many hundreds or thousands of agent objects.

At S12, the computing means accepts input of traffic data for the geographic area. The traffic data may be vehicular data and/or pedestrian data. The traffic data may include data that is obtained from one or more sensors within the given geographic area (the region of the traffic simulation). The traffic data may further include data related to current or upcoming weather, seasonality, prearranged events (such as concerts or sporting events), mobility flow, and correlated patterns in traffic from other geographic areas (adjacent geographic areas and non-adjacent geographic areas). The traffic data may relate to survey data, indicating - for example - the business of road segments or the use of public transport systems.

S11 may be preceded by a step of accepting input of preliminary traffic data for the geographic area. Any preliminary traffic data may be of a same or similar format to any later input traffic data. S11 may then execute the preliminary agent-based simulation model using the preliminary traffic data. Alternatively, the preliminary agent-based simulation model may be executed using placeholder or default agent values.

At S13, the computing means performs data assimilation on the preliminary simulation prediction and the traffic data to generate assimilated traffic data. Data assimilation is the process of integrating observational data into simulation models to improve the model' accuracy and predictive capabilities. In the context of traffic simulation in accordance with embodiments, this may involve combining real-time data from various sources, such as sensors and traffic cameras, with a simulation model (or models) to enhance the model's reliability and responsiveness. The assimilated traffic data may thus be considered as corrected or refined traffic data.

Data assimilation algorithms have been found to allow fusion of real-time data from diverse sources, including GPS devices, traffic sensors, and social media with simulation models in real-time, enabling more accurate predictions and adaptive control strategies. Data assimilation algorithms are able to quantify and incorporate uncertainties in both the model and the underlying data, thereby improving the robustness of traffic simulation models. Data assimilation algorithms have been found to enable integration with smart city initiatives: using the techniques herein to integrate traffic simulation models with other urban systems, such as energy, environment, and infrastructure, provides a holistic view for urban planning and management.

The skilled reader will appreciate the applicability of the techniques herein to such fields as traffic planning and engineering, where the techniques may be used for evaluating the impact of road infrastructure changes, traffic management strategies, and public transportation services. In the field of autonomous vehicle development, testing and evaluating the behaviour of self-driving cars in simulated environments may be provided by techniques herein. In the field of urban planning, the techniques herein allow for studying the impact of transportation systems on land use, air quality, and energy consumption. Beyond transport networks, the techniques herein may be extended to model other systems of mass facilitation. This versatility makes the approach a valuable asset for diverse industries and sectors seeking to simulate and optimise various complex systems. Moreover, the techniques herein address a significant technical drawback commonly observed in ABM literature within academia - namely the lack of compute power and scalability.

The techniques herein allow for fast and resource efficient data assimilation. The techniques allow for significant expansion on existing simulator's capabilities for integration into Digital Twin frameworks by allowing the simulator to utilise multiple types of real-world data. The techniques enhance existing simulators' resilience to corrupted or noisy data, as well as enhancing forecast precision. Further, the techniques preserve hardware resources and optimise hardware resource allocation in simulation tasks.

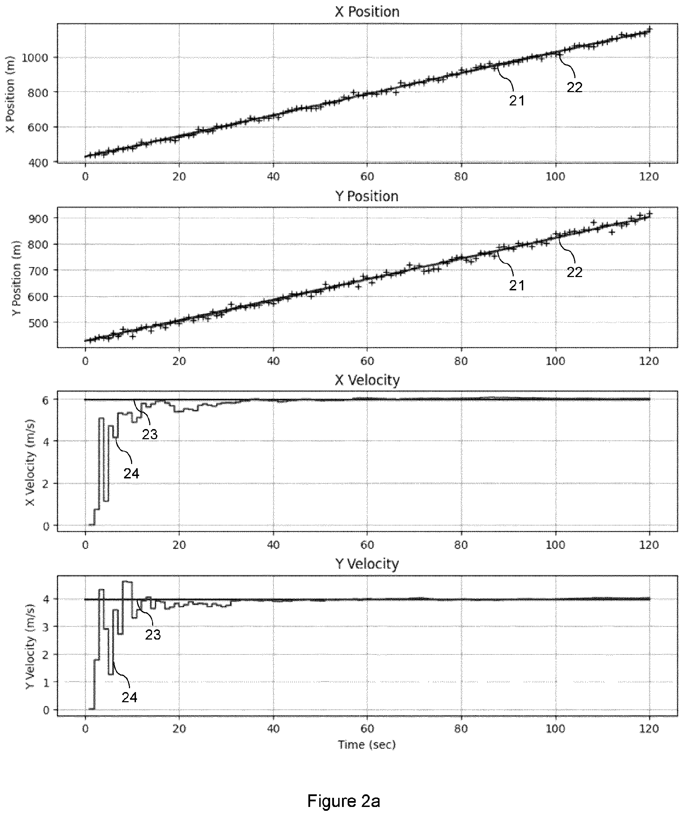

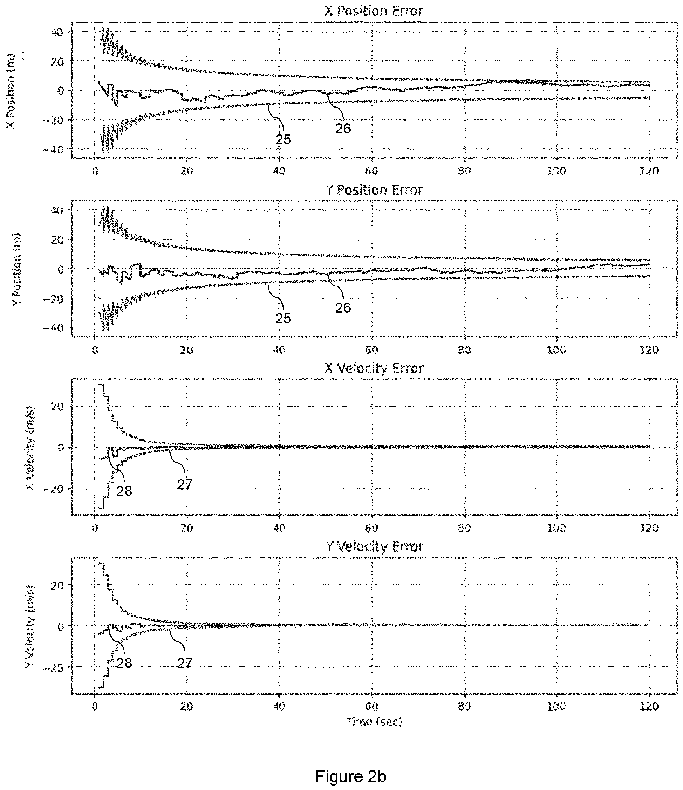

FIGURE 2 (formed of FIGURE 2a and FIGURE 2b) is a simple example of a data assimilation technique, namely the linear Kalman filter (also known as a linear quadratic estimator), which may be used in S13. The filter uses a series of measurements observed over time, including statistical noise and other inaccuracies, and produces estimates of unknown variables that tend to be more accurate than those based on a single measurement alone, by estimating a joint probability distribution over the variables for each timeframe. The filter may be constructed as a mean squared error minimiser. The filter is used here to predict the trajectory of a moving object at constant velocity in two-dimensional space through noisy measurements. Filtering in this context refers to the stochastic process related to the problem of determining the state of a system from an incomplete and potentially noisy set of observations.

The leftmost plots are time-series plots of a two-dimensional object, capturing position in the X-plane (top left), in the Y-plane (second down left), and capturing velocity in the X-plane (third down left), and in the Y-plane (bottom left). Curves 21 are the object positions and curves 22 are the Kalman position filters (note that these two curves substantially overlap in each position plot). Curves 23 are the object velocities and curves 24 are the Kalman velocity filters. Plus-shaped symbols are object position measurements, as acquired using a GPS sensor for example.

The rightmost plots are time-series plots of errors in the positions and velocities (top left, X-plane position error; second down left, Y-plane position error; third down right, X-plane velocity error; bottom right, Y-plane velocity error). Curves 25 are the object position errors and curves 26 are the Kalman position error filters. Curves 27 are the object velocity errors and curves 28 are the Kalman velocity error filters. Curves 25 and 27 are three-sigma bounds in this example.

The Kalman filter is a recursive estimator, where only the estimated state from the previous time step and the current measurement are required to compute the estimate for the current state. In contrast to batch estimation techniques, no history of observations and/or estimates is required. As observed, early on in the simulation the filter struggles to predict the movement of the object (the Kalman filter position and velocity errors are relatively large). However, as time moves forward, more sensory information is available, thus, the filter is able to home in on the object and predict the object trajectory with improved accuracy.

The linear Kalman filter is effective in the present example, but is not especially well-suited for data of high-dimensionality, such as that encountered in ABM traffic simulations. In some embodiments, performing data assimilation includes filtering the preliminary simulation and the traffic data using an ensemble Kalman filter. The ensemble Kalman filter (EnKF) as used for data assimilation allows for an improved time complexity of the algorithm, as well as allowing for the ability to assimilate extremely high-dimensional data that is now typical for real world applications.

The EnKF is a recursive filter suitable for problems with a large number of variables and has been employed for the discretisation of partial differential equations in geophysical models. The EnKF is a computational algorithm based on Monte Carlo techniques for solving the Bayesian update problem. Starting with a probability density function (PDF) representing the state of a modelled system (referred to as the prior), the EnKF combines Bayes' theorem with time advancement of the model and incorporates new data periodically. Unlike the above-described linear (original) Kalman filter, which assumes Gaussian PDFs and provides algebraic formulas for mean and covariance updates, the EnKF replaces the covariance matrix with a sample covariance computed from an ensemble of state vectors. One advantage of EnKFs is that advancing the PDF over time is achieved by independently advancing each member of the ensemble.

Other suitable filters, which are well-suited for handling high-dimensional data include other filters from the particle filter family and four-dimensional variational (4D-Var) assimilation techniques, which combine model dynamics, physics, and observational data to enhance the accuracy of initial conditions for improved simulations.

In some embodiments, the method for traffic simulation further comprises preprocessing traffic data by signal-processing filtering the traffic data. In this way, the techniques smooth the data, removing outliers while maintaining the dataset's trends and patterns relative to the original dataset. In turn, the accuracies of resultant simulation predictions are improved. Smoothing in this context may involve creation of an approximating function that attempts to capture important patterns in the data, while leaving out noise or other fine-scale structures and rapid phenomena. Optionally, the preprocessing step may involve conversion of the traffic data to a filetype suitable for input into the simulation model.

In some embodiments, the method for traffic simulation further comprises executing a microscopic agent-based simulation model using the assimilated traffic data as initial conditions. This allows the method to generate a simulation prediction of traffic in the geographic area. In some cases, the preliminary ABM simulation model and any other ABM simulation model may be the same. ABM simulation models typically use algorithms that typically built around discretised ordinary differential equation (ODE) solvers - for example Simulation of Urban MObility (SUMO) (Krajzewicz et al. 2012) - to update the vehicle's (or traffic participant's) speed and position.

In some embodiments, the method for traffic simulation further comprises augmenting the assimilated traffic data (or associated simulation model setup thereof) to form a plurality of augmented assimilated traffic data (or associated simulation model setups). That is, following the data assimilation process, the resultant corrected or refined traffic data may be adjusted or supplemented so as to correspond to a variety of modified states of traffic. A single modified state of traffic may be represented by a single set of augmented assimilated traffic data. The method may then comprise executing a plurality of microscopic agent-based simulation models using the plurality of augmented assimilated traffic data to generate a plurality of augmented simulation predictions of traffic in the geographic area. In this way, it is possible to analyse potential scenarios of the system state's evolution and to run multiple variants concurrently. Of course, the unaltered (original) assimilated traffic data may be retained and form the basis of a simulation model run for the purpose of knowing the forecast and evolution path for the non-augmented state.

In some embodiments, executing the plurality of microscopic agent-based simulation models using the plurality of augmented assimilated traffic data may include a step of generating a plurality of agent objects. This step may be performed using the augmented assimilated traffic data, such that each agent object represents a traffic participant and associated augmented assimilated traffic data. The method then includes a step of allocating each of the agent objects to one more of a plurality of processing units. These processing units may be, for instance of or in a graphical processing unit (GPU): a specialised electronic circuit initially designed to accelerate computer graphics and image processing (either on a video card or embedded on the motherboards, mobile phones, personal computers, workstations, and game consoles). The processing units may be individual cores, groups of cores, threads, thread blocks, or warps composed of parallel threads.

The method then includes - for each processing unit and for each allocated agent object - executing a microscopic traffic simulation model in parallel (e.g., a first processing unit executes a traffic simulation in respect of a first allocated agent object, and - substantially in parallel - a second processing unit executes a traffic simulation in respect of a second allocated agent object). In this way, the method simulated the behaviour of the traffic participants as represented by the agent objects.

In some embodiments, the method for traffic simulation further comprises accepting input of further traffic data for the geographic area and performing data assimilation on the further simulation predictions using the further traffic data. In this way, the method generates assimilated further traffic data. In this way, the traffic simulation may advance in time and supplement the results of the preceding time-step's simulation model with up-to-date traffic data. Of course, this process may be repeated indefinitely, assimilating the simulation prediction for each preceding time-step with further traffic data. Moreover, a further agent-based simulation model may be executed using any assimilated traffic data to generate a further simulation prediction of traffic in the geographic area. This process may be repeated for a predetermined number of iterations (corresponding to a predetermined number of timesteps) or until some convergence criterion is achieved.

In some embodiments, the act of performing data assimilation on any further simulation prediction using any further traffic data may be withheld or reserved until further traffic data is available. For instance, traffic sensors may be configured to repeatedly obtain and process traffic data at a predetermined frequency, which may be associated with a timespan slower than the timespan in which the computing means is able to execute one simulation iteration. In this way, the computing means idles until further traffic data is available, which ensures that each simulation iteration is performed in light of accurate traffic data. This is particularly advantageous when any simulation iteration is performed quicker than real-time.

In some embodiments, traffic data (preliminary, augmented, assimilated, or otherwise) comprises data obtained from or corresponds to a Digital Twin of the geographic area under consideration. The method thereby creates comprehensive and realistic DTs, offering a high level of reliability and accuracy in modelling real-world systems. A DT in this context is a digital model of the traffic system that serves as the effectively indistinguishable digital counterpart of the traffic system for such purposes as simulation, integration, testing, monitoring, and maintenance of the real-life system.

In some embodiments, traffic data (preliminary, augmented, assimilated, or otherwise) comprises sensor data. This sensor data may be real-world sensor data acquired in real-time from any or all of the following: GPS sensors or antennas; cellular network sensors or antennas; loop sensors; camera sensors; and vehicle parking sensors. The sensors may be on-board sensors, for example a GPS sensor or cellular (telecommunications) sensor provided within or on a vehicle or pedestrian, configured to transmit the position of the vehicle or pedestrian. Antenna signal triangulation may be used to determine traffic position. Alongside GPS data and cellular data, any other floating car data may be suitably used. Camera sensors may be used to remotely accumulate image data, upon which image processing techniques such as object detection may be used to provide vehicle or pedestrian positioning data. Vehicle parking sensors (either on-board or remote to the vehicle) may be used to indicate the parked position of vehicles, thereby providing, for example, parking facility occupation level. Of course, the sensor data may be historical sensor data, representative of a traffic system at some point in the past.

In some embodiments, any traffic simulation model includes a car-following model, used to model or determine how traffic participants (e.g., vehicles or pedestrians) follow one another on a roadway or path. For instance, the model may determine the speed of a vehicle in relation to the vehicle ahead of it. One such implementation of a suitable car-following model is Krauss' car-following model, which facilitates a no-collision environment. Of course, alternative car-following models (including Gipps' model (Gipps, 1981)) may be used. In addition, the traffic simulation model comprises either a lane-changing model or a junction (or intersection) management model (or both). A lane-changing model is used to determine lane choice on multi-lane roads and speed adjustments related to lane changing. A junction management model is used to determine the behaviour of traffic participants at different types of intersections in regard to - for example - right-of-way rules, gap acceptance, and avoiding junction blockage.

In one implementation, SUMO may be used as the traffic simulation model and lane-changing rules and intersection mechanics may follow those described in the work of Erdmann, J ("SUMO's lane-changing model", 2014) and Erdmann, J. & Krajzewicz ("SUMO's road intersection model", 2011). These models are built on top of earlier models used in SUMO, adding internal junction support to better represent vehicle behaviour while navigating complex intersections, as well as an improved, more complex hierarchy of lane and velocity selection choices that include strategic, tactical, cooperative and regulatory triggers. These updated rule sets are used by default in the latest version of SUMO and are meant to improve the accuracy of an already reliable model.

SUMO's lane-changing model determines vehicle's lane choice for a single simulation stem based on both the route of the vehicle, as well as historical and current traffic conditions in the vehicle's surrounding, and computes necessary changes in velocity for the vehicle itself and for obstructing vehicles in order to promote execution of aforementioned choice In this model, the road network consists of edges, which are one-way street segments with a fixed number of lanes and speed limit. Each edge is made up of parallel lanes. Vehicles are defined by a route comprising a sequence of edges, and during simulation, they move along lanes with some freedom in choosing which lane to use (unless restricted). Connectivity is defined at the lane level, where each lane may connect to zero or more other lanes. If a vehicle's current lane does not connect to the next edge on its route, it needs to change lanes to continue.

The lane-changing model considers the vehicle in front (leader) to determine a vehicle's speed, regardless of whether it's in the same lane or the preferred next lane. The car-following model defines the follower's speed based on the leader. Lane changes are only possible if there is enough space in the target lane and if the vehicle would not get too close to the leader or follower in that lane (as defined by the car-following model). If these conditions are not met, the vehicle experiences a "blocking leader" or "blocking follower".

SUMO's junction management model represents intersections as nodes, with incoming and outgoing edges (roads with one or more lanes). Inside an intersection, "internal lanes" connect incoming lanes to outgoing lanes. Vehicles move across these internal lanes just like they would on regular lanes. This allows for detailed vehicle tracking and modelling of intersection capacity.

Each lane may have multiple potential next lanes. These connections are defined by "links," forming a "lane-graph" where lanes are connected, distinct from the "intersection-graph" where intersections are connected by roads.

At most intersections, vehicles wait at the stop line before entering, allowing them to cross without conflicting traffic. However, for specific situations like left turns, SUMO allows waiting in the middle of the intersection. This is modelled by splitting internal lanes and introducing an "internal intersection" within the main one. Vehicles using these lanes pass the initial entry point and wait at the internal intersection instead. The manner in which right-of-way is determined at these internal intersections is the same as at regular ones. Again, the reader is directed to the work Erdmann, J. & Krajzewicz ("SUMO's road intersection model", 2011) for a full derivation and explanation of one example junction management model.

Techniques herein provide an algorithm for feeding real-world data into mobility simulators, optionally with a layer of raw data filtering and format conversion, and optionally with stages of combining the output of a simulation run or iteration ("background", or "state" data) and newly available data from the real world ("observation data") to produce a set of initial conditions for following simulation runs. This overall algorithm is also suitable for initialisation of ensemble simulation runs to explore multiple scenarios of system evolution. Embodiments herein allow for one to obtain a precise and stable simulated forecast of a system's state for the targeted time step(s). Data assimilation, including incorporation of observation data, allows one to obtain precise initial conditions for each subsequent step of simulated period, thus ensuring realistic initial conditions that promote accurate representation of a system's likely non-linear evolution.

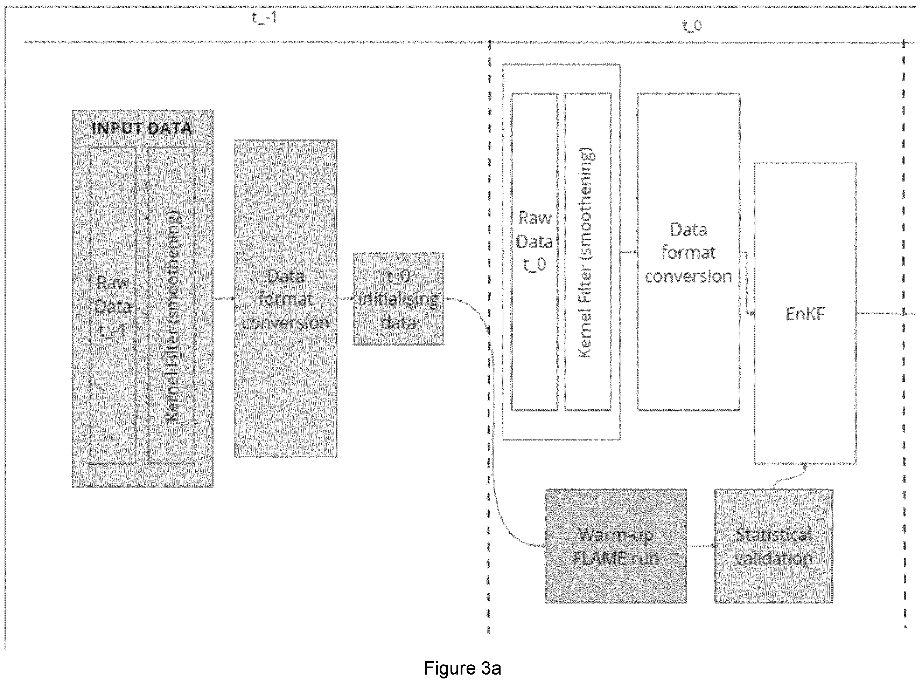

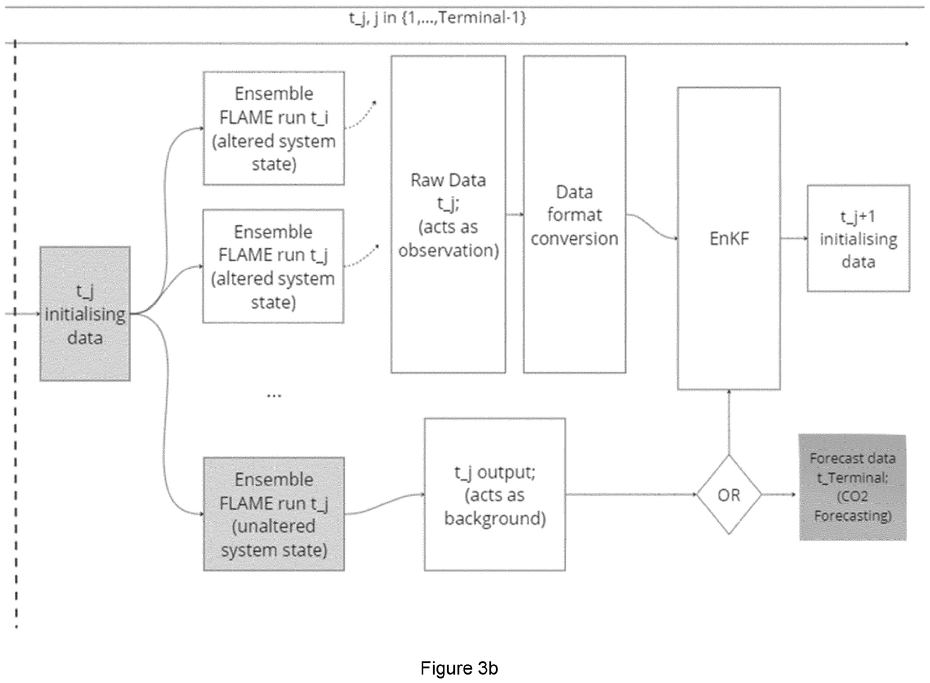

As an example of operation, FIGURE 3 (formed of FIGURE 3a and FIGURE 3b) demonstrates one implementation of a method for traffic simulation according to embodiments. In the described implementation, time-steps are represented by $t_i$, $i \in [-1, 0, ..., \tau]$. The terminal or final timestep, $\tau$, is the timestep for which the simulation forecast is made. In the present working implementation, computations required to update each agent's state are assigned to an individual Compute Unified Device Architecture (CUDA) core (floating point units in an NVIDIA graphics card) in a GPU via the framework's interface. CUDA is a proprietary and closed source parallel computing platform and application programming interface (API) that allows software to use certain types of GPUs for general purpose processing. CUDA cores are optimised to perform the required algebraic computations with higher efficiency as compared to a conventional CPU core. GPUs such as NVIDIA's possess many thousand cores and may be integrated into a High-Performance Computing (HPC) cluster for a seamless scaling effect. Of course, other GPUs from other manufacturers, including AMD and Intel, may be used. While the present approach does not change the computational complexity of the underlying simulation, the techniques herein significantly expand on the ability of GPUs to perform parallel computations, shifting the inflection point at which complexity growth starts to take effect on the execution speed of the simulation. The more CUDA cores available, the further the inflection point is shifted in terms of the number of agents in the simulation.

In the present example, SUMO-based simulations are used and mapping between the formal ABM agent specifications for SUMO with C based scripting and optimised CUDA code for GPU implementation is provided with the open-source software Flexible Large Scale Agent Modelling Environment for GPUs (FLAME-GPU). FLAME-GPU is an agent based simulation framework which possesses a parallel architecture of modern general purpose computing on GPUs (GPGPU) to increase the performance of complex systems simulations. FLAME-GPU demonstrates this by abstracting the GPU, and parallelism, away from modellers to provide a separation of concerns ensuring that models are described separately from their implementation. The increase in performance offered by the framework allows for large scale models to be constructed and simulated within a reasonable time. The framework presents a general approach to agent based simulation and is not restricted to any specific domain. It has been used for a range of simulation problems including pedestrian simulations, simple road network simulations, and cellular models of biological systems. To utilise FLAME-GPU, modellers map their complex system to an abstraction of agents (representing individuals with internal memory), messages (which allows agents to indirectly communicate via globally accessible message lists), and the environment (which represents information accessible to all agents within the system). The reader is directed to European patent application, application no. 24162384.2 for further information about this approach.

In the present example, the discretised ODE solver SUMO provides the microscopic traffic simulation model. Of course, other microscopic traffic simulation models and solvers are equally appropriate, including AIMSUN (Casas et al. 2010), MATsim (W Axhausen et al. 2016), ARCHISIM (Champion et al. 2001), and VISSIM (Fellendorf et al. 2010). Further, in the present example, parallelisation of processing is achieved using GPGPU; of course, in some embodiments, more traditional CPU architectures may be employed.

In the present context, the period $t_{-1}$ is the period prior to launching any simulation, in which the simulation's targets are formulated, initial data is gathered, and corresponding simulation variables are accordingly set. The period $t_{-1}$ may be considered as a set-up or initialisation stage. The period $t_0$ is, in effect, a warm-up stage of the simulation. In the period $t_0$, the method may execute the preliminary simulation model in order to run the simulation prior to the period of interest so as to obtain densely populated initial conditions. The succeeding period (or periods) $t_j$ comprises time steps corresponding to a period of interest.

During the period $t_{-1}$, the computing means is configured to receive raw data from a data supplier and/or directly from traffic sensors. These data may have various formats and dimensionalities, in which case raw data conversion processes may be executed prior to use of the data as $t_0$ initialisation data. For instance, raw data may be passed through a kernel filter (a signal-processing filter, or a kernel smoother) to ensure the data is smoothened and free of potential imperfections. As an example, GPS traffic position data may inaccurate due the presence of tunnels in roads or bad weather conditions. The kernel of the filter to be used may vary depending on the nature of the data; for instance, a Gaussian filter is particularly appropriate for continuous data, such as position data. This filtering process ensures that initial conditions described the state of the real world system closely, without any added distortion, which is particularly advantageous as the non-linear nature of the ABM simulations gives rise to high simulation sensitivity in respect of initial conditions.

Raw data (or raw filtered data) may be converted to into a data format compatible with the simulation engine in use. For instance, with the above-described FLAME configuration (using SUMO-based simulation engines), XML data structures are used an input. Hence, a conversion process may populate an XML file with the given real world data following smoothening, thereby forming $t_0$ initialising data (also referred to herein as preliminary traffic data). In this case, the preliminary traffic data is represented by an $m_t$-dimensional data vector $\boldsymbol{y}_t$, $t \in t_{-1}$; that is, the dimensionality of the vector may vary across time steps (for instance, the number of vehicles on a road will likely vary in time, such that the data dimensionality varies accordingly). Sparse data may be compressed at this time.

The period $t_0$ starts with a step of launching the simulation for the aforementioned period, using $\boldsymbol{y}_{t-1}$ as initial conditions for the warm-up simulation run. The output (also referred to herein as the preliminary simulation prediction) from the simulation may be subject to a sequence of statistical validation procedures in order to identify possible errors within the setup of the simulation. Such validation procedures include, but are not limited to, a comparison of aggregate statistics of the simulation with alternative means of numerical forecast using t-test, residual distribution test, RMSD, or other available statistical tools. Example alternative means of numerical forecast include time series forecast techniques such as autoregressive conditional heteroskedasticity (ATCH). In the event that the statistical validation procedures indicate likely errors in the simulation, simulation parameters may be adjusted and the warm-up simulation run may be repeated.

Note that the preliminary simulation prediction is represented in this example by an $n$-dimensional data vector $\boldsymbol{x}_t$, $t \in t_0$. At the end of the period $t_0$, the computing means is configured to receive another batch of raw data, in the same manner as in the period $t_{-1}$. This traffic data may be processed in the same manner as described above, yielding an $m_t$-dimensional data vector $\boldsymbol{y}_{t0}$.

The computing means may then initiate a process of data assimilation using an ensemble Kalman filter (EnKF) to yield initial conditions for the period $t_j$.

A classical linear Gaussian state-space model states, for observation y and state x:

$$y_t = H_t x_t + v_t \,,\ v_t \sim N_{m_t}(0, R_t)$$

$$x_t = M_t x_{t-1} + w_t \, , \; w_t \sim N_n(0, Q_t)$$

where $H_t$ is a matrix that maps state $x$ to the observation $y$, and matrix $M_t$ governs the temporal evolution of state $x$. The perturbations $v_t$ and $w_t$ are obtained by sampling from normal distributions $N_{m_t}$ and $N_n$, with mean 0 and variance $R_t$ and $Q_t$, respectively. $R_t$ and $Q_t$ are assumed to be known from historical data and are, in this context, historical data from road sensors, headings, traffic densities, weather, etc. The former equation is known as an observation model, and the latter equation is known as an evolution model.

The Kalman filter (and, by extension the EnKF) includes a prediction phase and an update phase. For the prediction phase, the Kalman filter produces estimates of the current state variables, along with their uncertainties. Once the outcome of the next measurement (corrupted with some error, including random noise) is observed, these estimates are updated using a weighted average, with more weight being given to estimates with greater certainty. Here, the prediction phase involves sampling from the forecast distribution $x_t|y_{1:t-1} \sim N_n\!\left(\widetilde{\mu}_t, \widetilde{\Sigma}_t\right)$ (i.e., state $x$ at time $t$ is conditioned on all previous observations $y$). The update phase involves sampling from the filtering (target) distribution $x_t|y_{1:t}$, given newly available observations $y_t$.

In this case, the forecast distribution $x_t|y_{1:t-1}$ is obtained through a simulation run, and one may immediately sample an ensemble from this distribution to reduce dimensionality:

$$\tilde{x}_t^{(1)}, \dots, \tilde{x}_t^{(N)},$$

where $\tilde{x}_t^{(i)} \sim N_n\!\left(\widetilde{\mu}_t, \widetilde{\Sigma}_t\right)$ holds. Sampling may be performed using a variety of techniques, including random sampling, use of a histogram and utilising frequencies, directly drawing samples from the distribution, etc. Ideally, the prior ensemble members would form a sample from the prior distribution. However, the ensemble members are not in general independent except in the initial ensemble, since every EnKF step ties them together. The ensemble members are, however, deemed to be approximately independent, and all calculations proceed as if they actually were independent.

The update phase may then be performed as follows:

$$\hat{x}_t^{(i)} = \tilde{x}_t^{(i)} + \widehat{K}_t\left(y_t^{(i)} - H_t \tilde{x}_t^{(i)}\right), i = 1, \dots, N,$$

where $\widehat{K}_t$ is the Kalman gain matrix defined as $\widehat{K}_t := \tilde{S}_t H_t'\left(H_t \tilde{S}_t H_t' + R_t\right)^{(-1)}$, $\tilde{S}_t$ being the sample (ensemble members) covariance. Return to full dimensionality (following the sampling process) may be ob-

tained by sampling $x_t|y_{1:t} \sim N_n(\hat{\mu}_t, \hat{S}_t)$. This (re)sampled data is used to initialise simulation runs in $t_j$ phase. EnKF is particularly effective and rapid as the filter operates on a thinned sample rather than the full data distribution and then returns to full dimensionality.

The period(s) $t_j$ corresponds to the time periods for which a forecast of a system's end state is obtainable. The period(s) $t_j$ may involve a step of launching the simulation, using the assimilated traffic data as initial conditions (or to inform the initial conditions) for the simulation run. Without any further modification to the data, this simulation provides a prediction of traffic in the geographic area. The unaltered system state enables forecasting (of, for example, anticipated $CO_2$ emissions in the geographic area) and enables further data assimilation (at the end of the period $t_j$) in cases where further simulation advances are sought (the simulation prediction providing an input into a further data assimilation process)

It is possible to augment the initial system state in order to analyse a variety of potential scenarios of the system state's evolution. The assimilated traffic data (and/or corresponding simulation parameters) may be augmented to form altered states (also referred to herein as augmented assimilated traffic data). Multiple variants of the system may form an ensemble of simulations (the term ensemble here is not to be confused with the use of the term ensemble in EnKF), which may be executed concurrently. Ensemble simulations may also be run for any given time period(s) $t_j$, $j \in (1,..,\tau)$, either for the purpose of obtaining a forecast or for the purpose of having a system state that closer resembles the evolution of conditions that took place within the actual real-world system. In cases where the simulation model allows one to run ensemble simulations faster than real-world acquisition may occur, the method may involve idling or awaiting input of further real-world data.

An algorithm for ensemble traffic simulation in period $t_j$ is as follows:

1. Set $j = 1$. At timepoint $t_j$, the possible ways that the system may evolve is determined. A set of initial system states is created, and the ensembles are fed with initialising data to start the simulation; in most cases, initialising data is that obtained from the assimilation step at $t_{j-1}$, unless one wishes to test a particular setup where this is not true, for instance using brand-new simulation parameters for comparison purposes.

2. Simulation ensembles are run to completion; $t_j$ output data is obtained for all ensembles.

3. The computing means identifies the scenario that has been followed by the real-world system (the "unaltered" state in this case).

4. If it is not required to perform simulations for $t_{j+1}$, $t_j$ output data may be used as forecast data to build necessary analytical predictions.

5. If necessary, the computing means idles until raw

data for $t_j$ is available, and the computing means performs raw data conversion processes, followed by EnKF data assimilation (as in the $t_0$ phase), to obtain corrected or refined forecast data for analytical predictions.

6. If it is required to perform simulations for $t_{j+1}$, the computing means idle until the raw data for $t_j$ is available, and the computing means performs raw data conversion processes, followed by EnKF data assimilation.

7. The assimilated data is ready to be used as initialising data for $t_{j+1}$.

8. Set $j = j + 1$, and repeat steps 1 to 8 until the desired forecast timepoint $t_\tau$ is reached.

As a worked example, consider the use of HERE live traffic data (from HERE Technologies), which may be configured to arrive in 15 minute intervals. The data comprises trips that select cars have taken throughout the given period, with origin and destination coordinates and a time stamp.

At $t_{-1}$ this data is aggregated into a bundle that represents $\Delta t$ period of interest (e.g., 1 hour), such that one has information about the combined trips taken. HERE data is provided filtered and smoothed, so in this worked example there is no need for any smoothening or filtering. Following aggregation, computing means passes the given data through a script that converts origin and destination coordinates to a set of time-stamped edge sequences that represent routes, all converted to an XML format that is easily read by FLAME. Here, vector x can be viewed as populated by tuples, where the first member of tuple is a time stamp, and a second member of tuple is an object that represents a route. At this point, one may load the file into FLAME and run a warm-up simulation run.

At the end of $t_0$, the warm-up run is finished and one has floating car data (FCD) output for the simulated period. Data is then extracted using a script, such that the data mimics the format in which the computing means receives HERE data: timestamped pairs of origins and destinations (ODs). As soon as real-world data for the period $t_0$ is received, the computing means is able to begin data assimilation. Briefly, the computing means performs the following:

1. Obtain an ensemble of $\tilde{x}_t^{(1)}, \ldots, \tilde{x}_t^{(N)}$, $t = t_0$. As a result, the computing means receives N time-stamped pairs of ODs

2. Calculate $\tilde{S}_t$. Find a suitable $H_t$ matrix (this is dependent on the dimensionality of the simulation output and background data; for many cases (where each state is mapped to an observation), this will be an identity matrix). $R_t$ is assumed to be known from historical data, and the computing means is able to calculate the Kalman gain, $\hat{K}_t$.

3. The computing means calculates $\hat{x}_t^{(i)}$

4. The computing means sampling of $x_t|y_{1:t}$, returning to full dimensionality, thereby providing initialising data for $t_1$.

The computing means is configured to set up several altered system states to launch multiple ensemble simulations to assess the period of $\Delta t$. By the end of the period, the computing means is able to either use simulation results for the most realistic ensemble, or perform further assimilation in the same fashion to acquire initialising conditions for $t_2$. The process is then repeatable for as many periods as required.

One suitable hardware implementation to perform traffic simulations in accordance with embodiments has the following specifications: Intel Core i7-5930K, NVIDIA GeForce RTX 3090 (24 GiB), 64 GB host memory, and running Ubuntu 20.04.6 LTS.

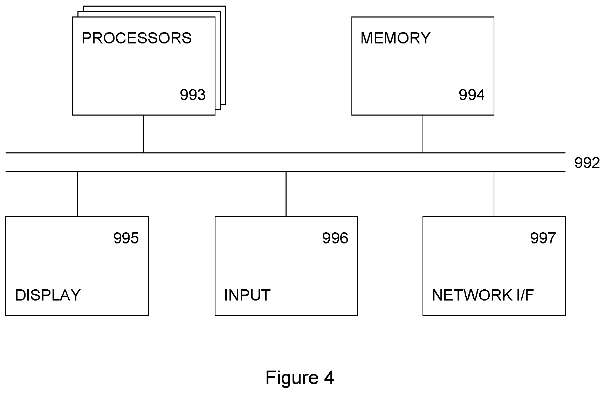

FIGURE 4 is a block diagram of a computing device, such as a data processing server, which embodies the present invention, and which may be used to implement a method for traffic simulation. The computing device comprises a plurality of processors or processing units 993 and memory, 994. Optionally, the computing device also includes a network interface 997 for communication with other computing devices, for example with other data storage devices or external data processing devices. An embodiment may be composed of a network of such computing devices.

Optionally, the computing device also includes one or more input mechanisms such as keyboard and mouse 996, and a display unit such as one or more monitors or screens 995. The components are connectable to one another via a bus 992.

The memory 994 may include a computer readable medium, a term which may refer to a single medium or multiple media (e.g., a centralised or distributed database and/or associated caches and servers) configured to carry computer-executable instructions or have data structures stored thereon. Computer-executable instructions may include, for example, instructions and data accessible by and causing a general purpose computer, special purpose computer, or special purpose processing device (e.g., one or more processors) to perform one or more functions or operations. Thus, the term "computer-readable storage medium" may also include any medium that is capable of storing, encoding or carrying a set of instructions for execution by the machine and that cause the machine to perform any one or more of the methods of the present disclosure. The term "computer-readable storage medium" may accordingly be taken to include, but not be limited to, solid-state memories, optical media and magnetic media. By way of example, and not limitation, such computer-readable media may include non-transitory computer-readable storage media, including Random Access Memory (RAM), Read-Only Memory (ROM), Electrically Erasable Programmable Read-Only Memory (EEPROM), Compact Disc Read-Only Memory (CD-ROM) or other optical disk storage, magnetic disk storage or other magnetic storage devices, flash memory devices (e.g., solid state memory devices).

The plurality of processors 993 is configured to control the computing device and execute processing operations, for example executing code stored in the memory to implement the method for traffic simulation and the associated simulation described here and in the claims. The memory 994 stores data being read and written by the plurality of plurality of processors 993. As referred to herein, a processor may include one or more general-purpose processing devices such as a microprocessor, central processing unit, or the like. The processor may include a complex instruction set computing (CISC) microprocessor, reduced instruction set computing (RISC) microprocessor, very long instruction word (VLIW) microprocessor, or a processor implementing other instruction sets or processors implementing a combination of instruction sets. The processor may also include one or more special-purpose processing devices such as an ASIC, a FPGA, a digital signal processor (DSP), network processor, or the like. In one or more embodiments, a processor is configured to execute instructions for performing the operations and steps discussed herein.

Display 995 may display a user interface. Input 996, in the form of a touchscreen or screen and keyboard and/or voice, may be used for user input. The user interface may be embodied as a user application shown on the display and optionally connected to the audio input/output of the user device for voice input and audio output. Local storage, for example of simulation parameters, may be provided by memory 994, and plurality of processors 993 may carry out background functions. The core functionality (execution of a simulation, for example) may preferably be implemented remotely from the user device, for example on the cloud.

The network interface (network I/F) 997 may be connected to a network, such as the internet, and is connectable to other such computing devices via the network. The network I/F 997 may control data input/output from/to other apparatus via the network. Other peripheral devices such as microphone, speakers, etc. may be included in the computing device.

Plurality of processors 993 may execute instructions stored on a portion of the memory 994 to exchange data between modules via bus 992 via network I/F 997 to external entities, such as traffic sensors.

Methods embodying the present invention may be carried out on a computing device such as that illustrated in FIGURE 4. Such a computing device need not have every component illustrated in FIGURE 4, and may be composed of a subset of those components. Methods embodying the present invention may be carried out by a single computing device in communication with one or more data storage servers via a network. The computing device may be a data storage itself storing preconfigured interventions, buffered sensor data, historical sensor data, multi-function optimisation models and parameters, etc.

A method embodying the present invention may be carried out by a plurality of computing devices operating in cooperation with one another. One or more of the plurality of computing devices may be a data storage server storing at least a portion of preconfigured simulation parameters, traffic network details, agent object data, etc.

The various methods described above may be implemented by a computer program. The computer program may include computer code (e.g., instructions) arranged to instruct a computer to perform the functions of one or more of the various methods described above. For example, the steps of the methods described in relation to FIGURE 1 may be performed by the computer code. The steps of the methods described above may be performed in any suitable order. The computer program and/or the code for performing such methods may be provided to an apparatus, such as a computer, on one or more computer readable media or, more generally, a computer program product. The computer readable media may be transitory or non-transitory. The one or more computer readable media could be, for example, an electronic, magnetic, optical, electromagnetic, infrared, or semiconductor system, or a propagation medium for data transmission, for example for downloading the code over the Internet. Alternatively, the one or more computer readable media could take the form of one or more physical computer readable media such as semiconductor or solid state memory, magnetic tape, a removable computer diskette, a random access memory (RAM), a read-only memory (ROM), a rigid magnetic disc, and an optical disk, such as a CD-ROM, CD-R/W or DVD. The instructions may also reside, completely or at least partially, within the memory 994 and/or within controller circuitry of plurality of processors 993 during execution thereof by the computing system, the memory 994 and the controller circuitry of plurality of processors 993 also constituting computer-readable storage media.

In an implementation, the modules, components and other features described herein may be implemented as discrete components or integrated in the functionality of hardware components such as ASICS, FPGAs, DSPs or similar devices.

A "hardware component" is a tangible (e.g., non-transitory) physical component (e.g., a set of one or more processors) capable of performing certain operations and may be configured or arranged in a certain physical manner. A hardware component may include dedicated circuitry or logic that is permanently configured to perform certain operations. A hardware component may comprise a special-purpose processor, such as an FPGA or an ASIC. A hardware component may also include programmable logic or circuitry that is temporarily configured by software to perform certain operations.

In addition, the modules and components may be implemented as firmware or functional circuitry within hardware devices. Further, the modules and components may be implemented in any combination of hardware devices and software components, or only in software (e.g., code stored or otherwise embodied in a machine-readable medium or in a transmission medium).

Unless specifically stated otherwise, as apparent from the following discussion, it is appreciated that throughout the description, discussions utilizing terms such as "receiving", "determining", "comparing", "enabling", "maintaining", "identifying", "obtaining", "accessing", or the like, refer to the actions and processes of a computer system, or similar electronic computing device, that manipulates and transforms data represented as physical (electronic) quantities within the computer system's registers and memories into other data similarly represented as physical quantities within the computer system memories or registers or other such information storage, transmission or display devices.

While certain embodiments have been described, these embodiments have been presented by way of example only, and are not intended to limit the scope of the inventions. Indeed, the novel methods and apparatuses described herein may be embodied in a variety of other forms; furthermore, various omissions, substitutions and changes in the form of methods and apparatus described herein may be made.

The following numbered statements are useful for understanding the present invention.

S1. A computer-implemented method for traffic simulation, the method comprising: executing a preliminary agent-based simulation model to generate a preliminary simulation prediction of traffic in a geographic area; accepting input of traffic data for the geographic area; performing data assimilation on the preliminary simulation prediction and the traffic data to generate assimilated traffic data.

S2. The computer-implemented method of statement S1, wherein performing data assimilation includes filtering the preliminary simulation prediction and the traffic data using an ensemble Kalman filter.

S3. The computer-implemented method of any preceding statement, further comprising: preprocessing traffic data by signal-processing filtering the traffic data and optionally converting the traffic data to a filetype suitable for input into the simulation model.

S4. The computer-implemented method of any preceding statement, further comprising: executing an agent-based simulation model using the assimilated traffic data to generate a simulation prediction of traffic in the geographic area.

S5. The computer-implemented method of any preceding statement, further comprising: augmenting the assimilated traffic data to form a plurality of augmented assimilated traffic data; and executing a plurality of agent-based simulation models using the plurality of augmented assimilated traffic data to generate a plurality of augmented simulation predictions of traffic in the geographic area.

S6. The computer-implemented method of statement S5, wherein executing the plurality of agent-based simulation models comprises: generating a plurality of agent objects using the plurality of augmented assimilated traffic data, each agent object representing a traffic participant and associated data; allocating the plurality of agent objects to a respective plurality of processing units used in parallel; for each processing unit in parallel, executing a traffic simulation model for simulating the behaviour of the traffic participant.

S7. The computer-implemented method of any of statements 4 to 6, further comprising: accepting input of further traffic data for the geographic area; and performing data assimilation on the further simulation predictions and the further traffic data to generate assimilated further traffic data.

S8. The computer-implemented method of statement S7, further comprising idling until the further traffic data is available prior to performing data assimilation.

S9. The computer-implemented method of statement S7 or statement S8, further comprising, for a predetermined number of timesteps, repeatedly: accepting input of further traffic data for the geographic area; performing data assimilation on the simulation prediction and the further traffic data to generate assimilated further traffic data; and executing a further agent-based simulation model using the assimilated traffic data to generate a further simulation prediction of traffic in the geographic area.

S10. The computer-implemented method of any preceding statement, wherein traffic data comprises data obtained from a digital twin of the geographic area.

S11 The computer-implemented method of any preceding statement, wherein the traffic data comprises sensor data, acquired from any or all of the following: GPS sensors or antennas; cellular network sensors or antennas; loop sensors; camera sensors; and vehicle parking sensors.

S12. The computer-implemented method of any preceding statement, wherein the traffic simulation model comprises a car-following model, and the traffic simulation model comprises a lane-changing model and/or a junction management model.

S13. A data processing apparatus comprising: means for accepting input of traffic data; and a processing unit configured to execute the computer-implemented method of any preceding statement.

S14. A computer program comprising instructions that, when the program is executed by a data processing apparatus, cause the data processing apparatus to carry out the method according to any of statements 1 to 12.

S15. A computer-readable medium comprising instructions that, when executed by a data processing apparatus, cause the data processing apparatus to carry out the method according to any of statements 1 to 12.

**Claims**

1. A computer-implemented method for traffic simulation, the method comprising:

   executing a preliminary agent-based simulation model to generate a preliminary simulation prediction of traffic in a geographic area;
   accepting input of traffic data for the geographic area;
   performing data assimilation on the preliminary simulation prediction and the traffic data to generate assimilated traffic data.

2. The computer-implemented method of claim 1, wherein performing data assimilation includes filtering the preliminary simulation prediction and the traffic data using an ensemble Kalman filter.

3. The computer-implemented method of any preceding claim, further comprising:
   preprocessing traffic data by signal-processing filtering the traffic data and optionally converting the traffic data to a filetype suitable for input into the simulation model.

4. The computer-implemented method of any preceding claim, further comprising:
   executing an agent-based simulation model using the assimilated traffic data to generate a simulation prediction of traffic in the geographic area.

5. The computer-implemented method of any preceding claim, further comprising:

   augmenting the assimilated traffic data to form a plurality of augmented assimilated traffic data; and
   executing a plurality of agent-based simulation models using the plurality of augmented assimilated traffic data to generate a plurality of augmented simulation predictions of traffic in the geographic area.

6. The computer-implemented method of claim 5, wherein executing the plurality of agent-based simulation models comprises:

   generating a plurality of agent objects using the plurality of augmented assimilated traffic data, each agent object representing a traffic participant and associated data;
   allocating the plurality of agent objects to a respective plurality of processing units used in parallel;
   for each processing unit in parallel, executing a traffic simulation model for simulating the behaviour of the traffic participant.

7. The computer-implemented method of any of claims 4 to 6, further comprising:

   accepting input of further traffic data for the geographic area; and
   performing data assimilation on the further simulation predictions and the further traffic data to generate assimilated further traffic data.

8. The computer-implemented method of claim 7, further comprising idling until the further traffic data is available prior to performing data assimilation.

9. The computer-implemented method of claim 7 or claim 8, further comprising, for a predetermined number of timesteps, repeatedly:

   accepting input of further traffic data for the geographic area;
   performing data assimilation on the simulation prediction and the further traffic data to generate assimilated further traffic data; and
   executing a further agent-based simulation model using the assimilated traffic data to generate a further simulation prediction of traffic in the geographic area.

10. The computer-implemented method of any preceding claim, wherein traffic data comprises data obtained from a digital twin of the geographic area.

11. The computer-implemented method of any preceding claim, wherein the traffic data comprises sensor data, acquired from any or all of the following:

    GPS sensors or antennas;
    cellular network sensors or antennas;
    loop sensors;
    camera sensors; and
    vehicle parking sensors.

12. The computer-implemented method of any preceding claim, wherein the traffic simulation model comprises a car-following model, and the traffic simulation model comprises a lane-changing model and/or a junction management model.

13. A data processing apparatus comprising:

    means for accepting input of traffic data; and
    a processing unit configured to execute the computer-implemented method of any preceding claim.

14. A computer program comprising instructions that, when the program is executed by a data processing apparatus, cause the data processing apparatus to carry out the method according to any of claims 1 to 12.

15. A computer-readable medium comprising instructions that, when executed by a data processing apparatus, cause the data processing apparatus to carry out the method according to any of claims 1 to 12.

**Amended claims in accordance with Rule 137(2) EPC.**

1. A computer-implemented method for traffic simulation, the method comprising:

   executing (S11) a preliminary agent-based simulation model to generate a preliminary simulation prediction of traffic in a geographic area;
   accepting (S12) input of traffic data for the geographic area;
   performing (S13) data assimilation on the preliminary simulation prediction and the traffic data to generate assimilated traffic data; and
   executing an agent-based simulation model using the assimilated traffic data to generate a simulation prediction of traffic in the geographic area.

2. The computer-implemented method of claim 1, wherein performing (S13) data assimilation includes filtering the preliminary simulation prediction and the traffic data using an ensemble Kalman filter.

3. The computer-implemented method of any preceding claim, further comprising:
   preprocessing traffic data by signal-processing filtering the traffic data and optionally converting the traffic data to a filetype suitable for input into the simulation model.

4. The computer-implemented method of any preceding claim, further comprising:

   augmenting the assimilated traffic data to form a plurality of augmented assimilated traffic data; and
   executing a plurality of agent-based simulation models using the plurality of augmented assimilated traffic data to generate a plurality of augmented simulation predictions of traffic in the geographic area.

5. The computer-implemented method of claim 4, wherein executing the plurality of agent-based simulation models comprises:

   generating a plurality of agent objects using the plurality of augmented assimilated traffic data, each agent object representing a traffic participant and associated data;
   allocating the plurality of agent objects to a respective plurality of processing units used in parallel;
   for each processing unit in parallel, executing a traffic simulation model for simulating the behaviour of the traffic participant.

6. The computer-implemented method of any of any preceding claims, further comprising:

   accepting input of further traffic data for the geographic area; and
   performing data assimilation on the further simulation predictions and the further traffic data to generate assimilated further traffic data.

7. The computer-implemented method of claim 6, further comprising idling until the further traffic data is available prior to performing data assimilation.

8. The computer-implemented method of claim 6 or claim 7, further comprising, for a predetermined number of timesteps, repeatedly:

   accepting input of further traffic data for the geographic area;
   performing data assimilation on the simulation prediction and the further traffic data to generate assimilated further traffic data; and
   executing a further agent-based simulation model using the assimilated traffic data to generate a further simulation prediction of traffic in the geographic area.

9. The computer-implemented method of any preceding claim, wherein traffic data comprises data obtained from a digital twin of the geographic area.

10. The computer-implemented method of any preceding claim, wherein the traffic data comprises sensor data, acquired from any or all of the following:

    GPS sensors or antennas;
    cellular network sensors or antennas;
    loop sensors;
    camera sensors; and
    vehicle parking sensors.

11. The computer-implemented method of any preceding claim, wherein the traffic simulation model comprises a car-following model, and the traffic simulation model comprises a lane-changing model and/or a junction management model.

12. A data processing apparatus comprising:

    means (996) for accepting input of traffic data;

and
a processing unit (993) configured to execute the computer-implemented method of any preceding claim.

13. A computer program comprising instructions that, when the program is executed by a data processing apparatus, cause the data processing apparatus to carry out the method according to any of claims 1 to 11.

14. A computer-readable medium comprising instructions that, when executed by a data processing apparatus, cause the data processing apparatus to carry out the method according to any of claims 1 to 11.

| Execute a preliminary agent-based simulation model to generate a preliminary simulation prediction of traffic in a geographic area | S11 |
|---|---|

| Accept input of traffic data for the geographic region | S12 |
|---|---|

| Perform data assimilation on the preliminary simulation prediction and the traffic data to generate assimilated traffic data | S13 |
|---|---|

Figure 1

Figure 2a

Figure 2b

Figure 3a

Figure 3b

PROCESSORS

993

MEMORY

994

992

995

DISPLAY

996

INPUT

997

NETWORK I/F

Figure 4

Europäisches
Patentamt
European
Patent Office
Office européen
des brevets

# EUROPEAN SEARCH REPORT

**Application Number**

EP 24 20 4641

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2024/233523 A1 (VOGEL MANUEL IVO [CH]) 11 July 2024 (2024-07-11) * paragraphs [0009], [0011], [0013], [0018], [0020] - [0023], [0037] - [0043], [0049], [0050], [0062] - [0064] * * figures 1, 2a, 3, 4 * | 1-15 | INV. G08G1/01 G06F30/20 |
| X | US 2022/335820 A1 (WANG MENG [CN] ET AL) 20 October 2022 (2022-10-20) * paragraphs [0007], [0013], [0022], [0023], [0036], [0071], [0076] - [0080] * * figures 1A, 3, 14A-C * | 1,11, 13-15 | |
| A | XIA CHAO ET AL: "Assimilating Eulerian and Lagrangian data in traffic-flow models", PHYSICA D, vol. 346, 1 May 2017 (2017-05-01), pages 59-72, XP029951942, ISSN: 0167-2789, DOI: 10.1016/J.PHYSD.2017.02.004 * the whole document * | 1-15 | **TECHNICAL FIELDS SEARCHED (IPC)** G08G G06F |

The present search report has been drawn up for all claims

| Place of search | Date of completion of the search | Examiner |
|---|---|---|
| The Hague | 27 January 2025 | Roxer, Adam |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 20 4641

This annex lists the patent family members relating to the patent documents cited in the above-mentioned European search report.
The members are as contained in the European Patent Office EDP file on
The European Patent Office is in no way liable for these particulars which are merely given for the purpose of information.

27-01-2025

| Patent document cited in search report | | Publication date | Patent family member(s) | | Publication date |
|---|---|---|---|---|---|
| US 2024233523 | A1 | 11-07-2024 | EP | 4401060 A1 | 17-07-2024 |
| | | | US | 2024233523 A1 | 11-07-2024 |
| US 2022335820 | A1 | 20-10-2022 | CN | 110969857 A | 07-04-2020 |
| | | | EP | 4060641 A1 | 21-09-2022 |
| | | | US | 2022335820 A1 | 20-10-2022 |
| | | | WO | 2021129227 A1 | 01-07-2021 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 24162384